# EUROPÄISCHE PATENTANMELDUNG

(11) **EP 2 043 130 A2**
(43) Veröffentlichungstag der Anmeldung: **01.04.2009**
(21) Anmeldenummer: 08015981.7
(22) Anmeldetag: 11.09.2008
(51) Int. Cl.: H01J 37/153, H01J 37/26, H01F 5/00, H01F 41/04, H01F 41/06, H01J 29/76, H05K 1/16

(54) **Multipolspulen**

(30) Priorität: 25.09.2007 DE 102007045874
(71) Anmelder: Ceos Corrected Electron Optical Systems GmbH, 69126 Heidelberg (DE)
(72) Erfinder: Zach, Joachim, 76684 Östringen (DE); Kallenbach, Matthias, 98714 Stützerbach (DE)
(74) Vertreter: Weber, Walter

(57) **Zusammenfassung**

Die Erfindung betrifft Multipolspulen (1, 2, 3, 4, 5, 6) zur Beeinflussung von Teilchenstrahlen mit mindestens zwei Spulen (1, 2), die eine gedachte Achse (10) konzentrisch einschließend angeordnet sind, wobei für jede Spule (1, 2, 3, 4, 5, 6) mindestens eine Windung (7) auf einer flexiblen Leiterplatte (8) durch aufgebrachte Leiterbahnen (9) angeordnet wird und die Leiterplatte (8) mindestens in einer Leiterplattenlage (11, 12, 13, 14) gerollt wird.

Solche Multipolspulen (1, 2, 3, 4, 5, 6) werden dadurch für eine Fehlerkorrektur in der Teilchenoptik geeignet, daß die Windungen (7) der Multipolspulen (1, 2, 3, 4, 5, 6) Fenster (16) bilden, deren Breite in Umfangsrichtung derart gewählt ist, daß keine sekundär erzeugten Störfelder auftreten, und deren Länge in Achsrichtung mindestens der Breite entspricht.

## Beschreibung

Die Erfindung betrifft Multipolspulen zur Beeinflussung von Teilchenstrahlen mit mindestens zwei Spulen, die eine gedachte Achse konzentrisch einschließend, angeordnet sind, wobei für jede Spule mindestens eine Windung auf einer flexiblen Leiterplatte durch aufgebrachte Leiterbahnen angeordnet wird, und die Leiterplatte mindestens in einer Leiterplattenlage gerollt wird.

Aus der US 3,702,450 ist ein Multipolelement der eingangs genannten Art bekannt. Dabei sind zwei Spulen mit je zwei Hälften auf beiden Seiten des Strahls um 90° gedreht angeordnet und lenken den Strahl in x und y-Richtung aus. Dies dient beispielsweise dazu, mittels eines gescannten Strahls ein Bild auf einem Bildschirm aufzubauen, eine Femsehbildröhre ist beispielhaft erwähnt. Die Spulen sind von einem Mittelpunkt ausgehende, bzw. dort endende Spiralen, die beidseitig auf einer Leiterplatte angebracht sind. Diese wird gerollt und mit einer Isolierschicht abgedeckt in ein Stahlrohr eingebracht. Hier geht es also bei der Beeinflussung des Teilchenstrahls nur darum, einen punktförmigen Strahl abzulenken. Für diesen Zweck sind die Spulen, welche spiralförmige Windungen, bis zu einem Mittelpunkt reichend aufweisen, brauchbar, da es lediglich darauf ankommt, den Strahl mit den für die Auslenkung erforderlichen elektromagnetischen Kräften zu beaufschlagen. Für eine Fehlerkorrektur in der Teilchenoptik, bei der es um die Übertragung fehlerfreier Bilder höchster Auflösung geht, sind die Spulen dieser Schrift ungeeignet, da sie keine reinen Polfelder erzeugen, und sie daher die Bedingungen für eine solche Fehlerkorrektur nicht erfüllen können.

Das Gebiet der Erfindung betrifft jedoch die Beeinflussung von Teilchenstrahlen, also Ionen- oder Elektronenstrahlen in der Teilchenoptik mit dem Ziel, Fehler zu korrigieren. Seit O. Scherzer 1947 aufzeigte, daß sich der Strahlengang von Elektronenlinsen durch nicht rotationssymmetrische Linsen korrigieren läßt (O. Scherzer: "Sphärische und chromatische Korrektur von Elektronen-Linsen" OPTIK, DE, JENA, 1947, Seiten 114 - 132, XP002090897, ISSN: 0863-0259), findet diese Art der Korrektur allgemein Anwendung (David C. Joy "The Aberration Corrected SEM" - http: //www.cccl.nist.gov/812/conference/2005_Talks/Joy.pdf oder David B. Williams and C. Barry Carter "Transmission Electron Microscopy", ISBN 0-306-45324-X, insbesondere S. 93). Dort sind Dipole, Quadrupole, Hexapole und Oktopole beschrieben, bei welchen elektronenmagnetische Spulen derart angeordnet sind, daß sie Magnetfelder erzeugen, die konzentrisch um eine gedachte Achse angeordnet sind, wobei sich Süd- und Nordpole entlang des Umfangs abwechseln. Dadurch kann ein Elektronen- oder auch ein Ionenstrahl, der im Bereich der Achse (optische Achse) durch die Spulenanordnung hindurchgeht zur Korrektur von Fehlern beeinflußt werden.

Die auf O. Scherzer zurückgehende Fehlerkorrektur beruht darauf, daß z. B. Öffnungsfehler und Farbfehler in der Teilchenoptik durch Abweichungen des Strahlengangs von der Rotationssymmetrie korrigierbar sind. Die Grundbedingung dafür ist, daß Multipole auf einen Strahlengang derart wirken, daß eine Verzeichnung des Strahlengangs in zwei Hauptschnitten erfolgt, unter der Bedingung, "daß zwei in aufeinander senkrechten Hauptschnitten verlaufende Strahlen, die die Objektmitte unter gleichem Winkel zur optischen Achse verlassen, in der Bildmitte unter gleichem Winkel zur optischen Achse eintreffen." (Scherzer, a.a.O.). Dies bedeutet, daß diese Verzeichnung wieder völlig aufgehoben wird und dadurch wieder eine absolut verzeichnungsfreie Abbildung möglich ist. Bezüglich der Bewirkung der Korrekturen wird beispielhaft auf Scherzer 1947 (a.a.O.) verwiesen. Das Grundprinzip beruht darauf, daß beispielsweise für einen Achspunkt der Gegenstandsebene die Fundamentalbahnen des Strahlenverlaufs in einer x-Ebene und einer y-Ebene derart verlaufen, daß zwei astigmatische Zwischenbilder entstehen und eine Korrektur für die Strahlen in der x-Ebene dort vorgenommen wird, wo die Fundamentalbahn der Strahlen in der y-Ebene durch die optische Achse geht und die Korrektur für die Strahlen in der y-Ebene dort, wo die Fundamentalbahn der Strahlen in der x-Ebene durch die optische Achse geht. In dieser Weise können auch Korrekturen für den außeraxialen Strahlenverlauf vorgenommen werden, wobei auch andere Bereiche des Strahlverlaufs nutzbar sind, wenn der Strahlenverlauf dort unrund ist. Dies bedeutet, daß in dem Bereich der optischen Achse, in dem die Fehlerkorrektur zu erfolgen hat, reine Polfelder der Multipole vorhanden sein müssen, weil sonst die o. g. Bedingung nicht mehr erfüllt ist, damit eine Bildverzeichnung zurückbleiben würde und das Bild somit unbrauchbar wäre. Damit ist die Erzeugung reiner Mehrpolfelder absolute Voraussetzung einer Fehlerkorrektur, und je besser dies gelingt, desto besser ist die Bildqualität und die erzielbare Bildauflösung.

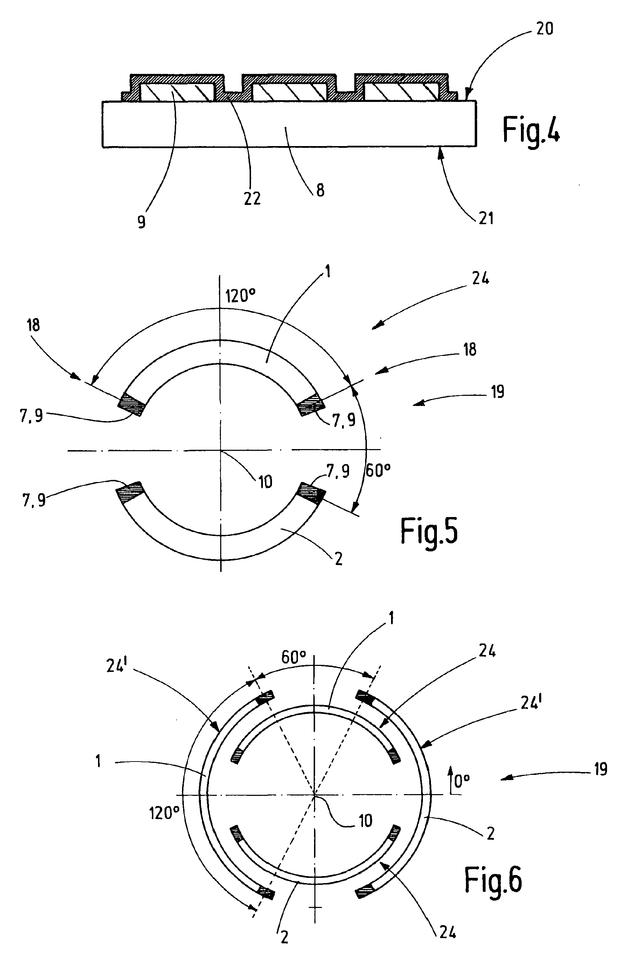

Die Multipole des Standes der Technik bezüglich der Fehlerkorrektur in der Teilchenoptik entsprechen der Darstellung in David B. Williams and C. Barry Carter, S. 93, Figur 6.8 (D) oder J. Zach und M. Haider "Next Generation of Electron Microscopes" in "NanoS, The business guide for the nanotechnology industry" (2007, Guide 08, ISSN: 1614-7847). Es handelt sich um in Richtung der optischen Achse weisende Stege, die mit Leitungsdrähten umwickelt sind. Derartige Multipole benötigen einen großen Bauraum (bei der Abbildung der letztgenannten Veröffentlichung, Seite 27, besonders gut sichtbar), weisen wegen des großen Abstandes von der Achse Felder auf, die uneffektiv auf den Bereich der Achse wirken und sie sind nicht in genau reproduzierbarer Weise herstellbar, da es beim Wickeln der Drähte sowohl bei der Handwicklung, als auch bei Maschinenwicklungen immer zu Abweichungen kommt.

Im Unterschied dazu lehren die US 6,982,504 B2**, die** US 4,271,370 und die US 3,736,543 Multipole zur Erzeugung von Drehmomenten für Motoren, für Strommeßgeräte oder ähnliches. Dabei weisen die Multipolelemente spiralförmige Wicklungen auf, die bis zum Mittelpunkt der der Spirale reichen: Im Mittelpunkt oder dem mittleren Bereich ist dann einer der beiden Stromanschlüsse der spiralförmigen Wicklung vorgesehen. Mit diesen Wicklungen ist die Erzeugung reiner Polfelder, die bei entsprechender Anordnung der Multipole gem. den Grundlagen von O. Scherzer (a.a.O.) ein verzeichnungsfreies Bild nach den vorgenommenen Korrekturen ermöglichen, völlig ausgeschlossen. Dasselbe gilt für Wicklungen, die zwar Fenster aufweisen, welche jedoch durch Wicklungen versetzt angeordneter Multipole überdeckt sind. Da es bei der Erzeugung von Drehmomenten auch nicht auf reine Mehrpolfelder ankommt, sondern lediglich auf optimale Drehmomenterzeugung, erwartet es ein Fachmann des Gebiets der Teilchenoptik auch nicht, in diesem Bereich der Elektromechanik eine Anregung für sein Gebiet zu finden.

Bei der US 3,587,019**,** der US 3,466,586 und der US 3,466,580 geht es wie bei der eingangs erwähnten US 3,702,450 um das Scannen eines Strahls, wobei bei diesen Schriften jedoch im Gegensatz zur letztgenannten keine Spulen mit Windungen angeordnet sind, sondern die für das Scannen erforderlichen Felder mittels Leiterbahnen auf Leiterplatten erzeugt werden, welche rechteckige Wellenformen in der Art von Mäandern aufweisen. Letztere werden dann mittels mehrerer Leiterplattenlagen so übereinandergelegt, daß Mehrpolfelder für die Strahlablenkung erzeugt werden können. Diese Felder sind jedoch ebenfalls viel zu inhomogen, um verzeichnungsfreie Bilder nach den Grundlagen von O. Scherzer erzeugen zu können.

Schließlich lehrt auch die EP 0153 131 A2 eine Spulenanordnung zur Erzeugung von Multipolfeldern. Die Spulenanordnung besteht jedoch aus Polspulen, die als schiefe Parallelogramme um einen Zylinder gewunden sind. Auch diese Multipolfelder sind wegen ihrer schiefen Lage zur Achse des Zylinders nicht dazu geeignet, nach O. Scherzer eine Abweichung eines Strahls von der Rotationssymmetrie, mit nachheriger verzeichnungsfreier Wiederherstellung derselben, zu erzielen.

Der Erfindung liegt daher die Aufgabe zugrunde, Multipolspulen der eingangs genannten Art verfügbar zu machen, die für eine Fehlerkorrektur in der Teilchenoptik geeignet sind. Dabei sollen sie bei geringem Bauraum effektive Felder im Bereich einer gedachten Achse erzeugen und die Multipolspulen sollen in reproduzierbarer Weise mit hoher Genauigkeit herstellbar sein.

Die Aufgabe wird erfindungsgemäß dadurch gelöst, daß die Windungen der Multipolspulen Fenster bilden, deren Breite in Umfangsrichtung derart gewählt ist, daß keine sekundär erzeugten Störfelder auftreten, und deren Länge in Achsrichtung mindestens der Breite entspricht.

Bei den erfindungsgemäßen Multipolspulen handelt es sich im Gegensatz zu den oben genannten Patentschriften um Linsen für die Teilchenoptik. Neben der Drehmomenterzeugung sind auch Kraftfelder, die einen Strahl auslenken, also die Vorrichtungen zum Scannen, keine Linsen. Beim Scannen geht es nur um die Verschiebung eines Strahls, um einen Bildfleck auf einer bestimmten Fläche zu erzeugen. Mit diesem wird durch Orts- und Intensitätsmodulation in einem bestimmten Zeitintervall das Bild erzeugt. Bei der Linsenfunktion der erfindungsgemäßen Multipolspulen geht es darum, Fehler dieses Bildflecks selbst zu beseitigen, damit dieser auf der Fläche auch als sauberer Punkt abgebildet ist. So müssen beispielsweise sphärische Aberration, chromatische Aberration oder ein Astigmatismus beseitigt werden, damit dieser Bildfleck ein Punkt mit klaren Begrenzungen und nicht ein verzerrter Fleck mit verschwommenen Grenzen ist. Dasselbe gilt natürlich für die Übertragung eines ganzen oder teilweisen Bildinhalts als Ganzes mit einem Strahl ohne Scannung. Eine solche Fehlerkorrektur kann an einem TEM (Transmissionselektronenmikroskop), einem SEM (scanning electron microscope) oder einem STEM (scanning transmission electron microscope) vorgenommen werden. Ein weiterer Einsatz solcher Multipolelemente zur Fehlerbeseitigung kann auch eine Justage zum Ausgleich von Baufehlern sein, beispielsweise zur Korrektur der optischen Achse. Die Beseitigung von Fehlern findet in bekannter Art mit einem Korrektor statt. Dies geht bezüglich der Grundlagen auf O. Scherzer (1947, a.a.O.) zurück. Bei J. Zach und M. Haider (a.a.O.) ist dies beschrieben. Bei der Erfindung geht es um die Ausgestaltung eines Teilelements eines solchen Korrektors, nämlich einer Multipolspule, von denen mindestens zwei, meistens jedoch viele, in einem Korrektor angeordnet sein müssen.

Wegen dieser Beeinflussung eines Teilchenstrahls, als gescannter oder ungescannter Strahl zur Fehlerkorrektur, werden derartige Multipolspulen auch als Linsen bezeichnet (siehe Williams and Carter a.a.O, S. 97), da sie wie die Linsen in der Lichtoptik auf den Lichtstrahl auf den Teilchenstrahl wirken. Entsprechend einer klar definierten Formgebung bei Linsen in der Lichtoptik muß bei den Linsen der Teilchenoptik, einschließlich der unrunden Linsen, wie den Multipolspulen, ein reines Feld vorhanden sein. Dies gilt für die Multipolspulen bezüglich des Feldlinienverlaufs in Umfangsrichtung und in Achsrichtung, damit nach mindestens zwei astigmatischen Abbildungen durch mindestens zwei Multipolspulen eines solchen Korrektors eine verzerrungsfreie Abbildung wieder möglich ist. Derartige Multipolspulen gab es bisher nur als die oben genannten gewickelten Spulenanordnungen, bei denen für einen Quadrupol beispielsweise vier Eisenkerne mit Leitungsdrähten umwickelt waren. Daß dies zu einem sehr großen Bauraum führt, ist bei der oben genannten Abbildung eines Zwölfpols (J. Zach, M. Haider, a.a.O., Seite 27) gut sichtbar. Die Geometrie solcher Multipole führte nicht nur zur Erzeugung des gewollten Multipolfeldes, sondern verursachte auch gleichzeitig erzeugte sekundäre Störfelder, oft Multipolfelder. So kann beispielsweise ein primär erzeugtes Dipolfeld mit einem sekundär erzeugten Hexapolfeld überlagert sein.

Will man Multipolspulen der eingangs genannten Art (wie das der US 3,702,450) überhaupt für eine derartige Linsenfunktion geeignet machen, ist es erforderlich, sie so auszugestalten, daß möglichst reine Polfelder im erforderlichen Wirkbereich, also im Bereich der optischen Achse, entstehen, die auch möglichst frei von Störfeldern sind.

Dazu ist der Grundgedanke der Erfindung, daß die Windungen der Multipolspulen Fenster bilden. Fenster in diesem Sinn bedeutet natürlich nicht nur, daß sich dort keine Wicklungen befinden. Es bedeutet ebenso, daß dort keine Anschlußleitungen für die Wicklungen verlegt sind, da solche erhebliche Störfelder verursachen würden, so daß reine Polfelder nicht mehr erzeugbar sind.

Die Bemessung dieser Fenster ist für die Qualität der erzeugten Felder und damit für den Erfolg der Korrekturen entscheidend. Bezüglich der Fensterbreite, dies ist in Umfangsrichtung, gibt es ein Optimum der Bemessung, die jedoch von der Polanzahl abhängig ist. Diese Bemessung läßt sich jedoch dahingehend definieren, daß sie so zu erfolgen hat, daß keine sekundär erzeugten Störfelder entstehen. Dies läßt sich für die jeweilige Polanzahl durch Versuch oder rechnerisch ermitteln. Ein solches Optimum liegt für einen Dipol bei einer Fensterbreite von ungefähr 120°. Bei einer Polanzahl von vier oder mehr Spulen sollte, sofern die Spulen in einer Umfangsfläche angeordnet sind, die geometrisch maximal mögliche Breite gewählt werden, indem die Multipolspulen unmittelbar aneinandergereiht sind. Dies bedeutet, daß die einzelnen Spulen in Umfangsrichtung bezüglich der Strahldurchtrittsöffnung unmittelbar nebeneinander liegen und der Raum zwischen den Windungen der jeweiligen Spulen so eng gewählt ist, wie dies ohne störende gegenseitige Beeinflussung möglich ist. Damit sind die leiterfreien Räume weitgehend für die Fenstergröße nutzbar. In diesem Fall liegt also das Optimum bei der geometrisch maximalen Breie.

Bezüglich der Fensterhöhe in Achsrichtung sollte diese mindestens der Breite entsprechen, da sonst keine effektiven Felder mehr erzeugt werden können. Effektiv in diesem Sinne ist die Wirkung auf den Fundamentalbahnverlauf der Teilchenstrahlen und diese Wirkung hängt von der jeweiligen Korrekturmaßnahme ab. Da eine große Anzahl von Fehlern auftreten können, wobei jeder Fehler wiederum in verschiedenen Ordnungen auftreten kann, ist hier eine abschließende Aufzählung nicht möglich. Die Möglichkeiten von Korrekturmaßnahmen sind Inhalt einer großen Anzahl von Patentschriften und wissenschaftlichen Veröffentlichungen.

In der Regel ist es jedoch zweckmäßig, daß die Windungen im Wesentlichen rechteckförmige Fenster bilden, wobei die langen Seiten der Fenster in Achsenrichtung eine derartige Länge aufweisen, daß .entlang der Achse eine homogene Multipolfeldstärke in einer Ausdehnung entsteht, die den für die gewünschte Fehlerkorrektur erforderlichen Fundamentalbahnverlauf der Teilchenstrahlen erzeugt. Dabei gibt es für die langen Seiten der Fenster, also die Fensterhöhe in Achsrichtung keine geometrische Begrenzung nach oben, die Bemessung richtet sich somit nach der Erzielung des gewünschten Fundamentalbahnverlaufs, was rechnerisch oder durch Versuch für die jeweilige Korrekturmaßnahme ermittelt werden kann.

Aber auch bezüglich der Fensterbreite kann die geometrische Begrenzung, die durch die in einer Umfangsfläche unterzubringende Anzahl von Polen gegeben ist, überwunden werden, indem zur Erzielung großer Fenster die Multipolspulen in verschiedenen Lagen angeordnet sind, und sich die Spulen überlappen. In diesem Fall ist die geometrische Begrenzung durch eine Umfangsfläche für die Fensterbreite überwunden und sie ist durch Versuch oder Berechnung im Hinblick auf die Vermeidung sekundärer Störfelderzeugungen zu optimieren.

Dann können beispielsweise die Pole einer Multipolspule auf zwei Umfangsflächen verteilt werden, so daß jeweils die Hälfte der Polspulen auf einer inneren und die Hälfte der Polspulen auf einer weiter außen liegenden Umfangsfläche liegen. Die letzteren sind dann gegenüber den erstgenannten Polspulen derart versetzt, daß ihre Mitte jeweils genau zwischen zwei der erstgenannten Polspulen liegt (siehe Darstellung in Fig. 6). Die Teilung ist also derart versetzt, daß sich auch bezüglich der zwei Lagen von Polspulen eine regelmäßige Teilung ergibt.

Die erfindungsgemäßen Mehrpolspulen weisen gegenüber den gewickelten Mehrpolspulen viele entscheidende Vorteile auf:

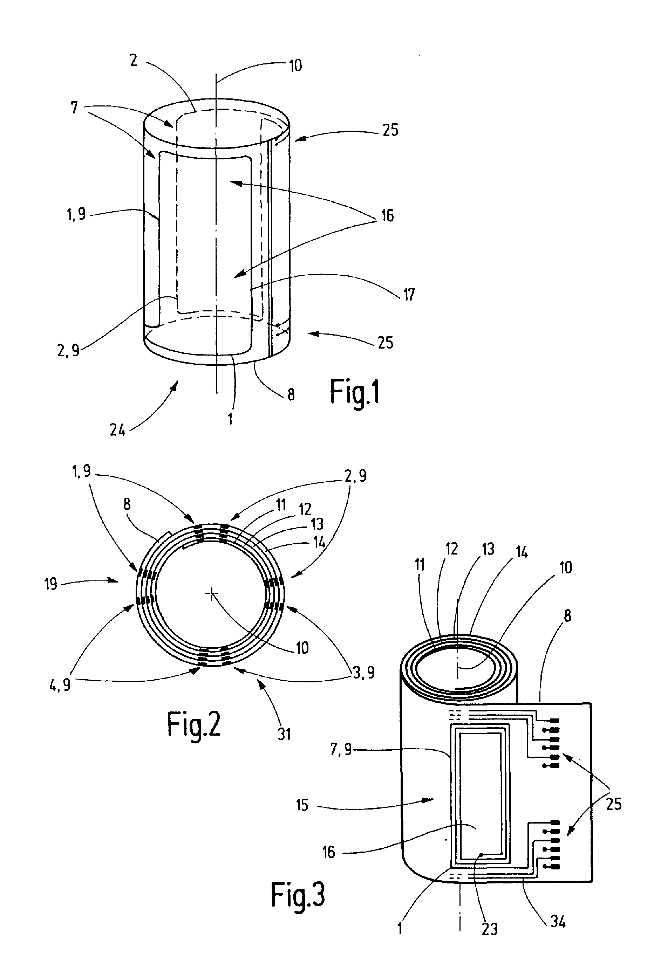

Das Wesentlichste ist, daß die auf den Leiterplatten angeordneten, als Wicklungen dienende Leiterbahnen zu Spulen führen, die eine weit geringere Höhe in radialer Richtung aufweisen. Es ist also nicht mehr erforderlich, erzeugte Magnetfelder, wie bei den gewickelten Spulen, durch Eisenkerne über eine längere Strecke an den Strahl heranzuführen, wie dies beispielsweise in der Abbildung in NanoS (a.a.O, Seite 23) zu sehen ist. Die sehr flach gebauten Spulen, die nur die Dicke einer oder mehrerer Leiterplattenlagen aufweisen (siehe Fig. 2), können auch ohne Eisenkerne das erforderliche, auf den Strahl wirkende Magnetfeld erzeugen, wobei auch eine Einfügung eines Eisenkerns die flache Bauweise kaum verändert. Dadurch wird das Feld in unmittelbarer Nähe des Einsatzbereiches erzeugt, so daß dieses wesentlich reiner ist und auch keine sekundären Störfelder auftreten können. Die Felder sind durch diese Nähe zum Einsatzort stärker und es sind reine Multipolfelder mit einer ausreichend ausgedehnten homogenen Multipolfeldstärke in Achsrichtung. Die Multipolfelder können im Vergleich zu den bekannten Multipollinsen mit geringerem Strombedarf erzeugt werden. Vor allem ist es dadurch auch möglich, die benötigten Felder mit einer wesentlich geringeren Anzahl von Windungen zu erzeugen. Dies führt aber dazu, daß die Bauhöhe noch mehr verringert werden kann, wodurch die erzeugten Felder noch näher an ihren Einsatzort herangerückt werden können und sich so die vorgenannten Vorteile noch mehr verstärken. Auf diese Weise sind die Multipolspulen der Erfindung bei einem Bruchteil der Bauhöhe um ein Vielfaches effektiver und besser.

Weiterhin kommt hinzu, daß der Verlauf der Leiterbahnen innerhalb kleinster Toleranzbereiche vorgebbar ist, was wiederum einer größeren Exaktheit der Felder zugute kommt. Dies ist gerade bei der Fehlerkorrektur im Gegensatz zu der Strahlablenkungsvorrichtung von Scanneinrichtungen von viel höherer Bedeutung, da Fehlerkorrekturen durch eine Unexaktheit der Felder unmöglich werden. Die Strahlablenkungsvorrichtungen von Scanneinrichtungen haben diesbezüglich keine derart hohen Anforderungen, da die reine Verschiebung eines Bildpunktes auf einer Fläche an die Exaktheit der Felder wesentlich geringere Anforderungen stellt. Die genannten Fenster sind dazu gar nicht erforderlich.

Die erzielbaren engen Toleranzbereiche waren bei den bisher gebräuchlichen gewickelten Spulen gar nicht möglich. Trotz dieser Exaktheit der erfindungsgemäßen Mehrpolspulen und ihrer wesentlich geringeren Baugröße ist ihre Herstellung mit bedeutend geringerem Aufwand verbunden und daher preiswerter.

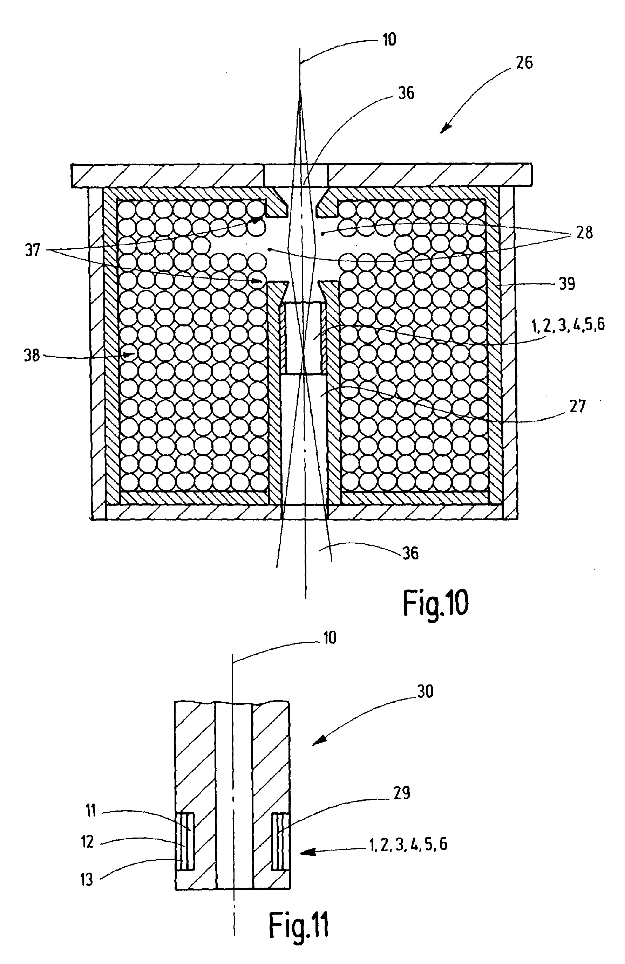

Ein weiterer bedeutender Vorteil der geringen Bauhöhe besteht darin, daß Korrektoren kleinster Bauweise möglich sind, die sich an Stellen eines Geräts, beispielsweise eines Elektronenmikroskops, einfügen lassen, an denen die bisherigen Korrektoren wegen ihrer Größe nicht unterzubringen waren (siehe Fig. 10 und zugehörige Beschreibung).

Eine Anordnung von Multipolspulen in mehreren Ebenen ist bei den gewickelten Spulen mit Eisenkernen wegen ihrer ohnehin schon viel zu großen radialen Bauhöhe überhaupt nicht möglich. Dies gilt sowohl für Spulen eines Multipols, die überlappend in verschiedenen Lagen angeordnet sind, als auch für verschiedene Multipolspulen, z. B. ein Hexapol und ein Oktupol, die in derselben Position zur Achse in verschiedenen übereinanderliegenden Lagen angeordnet werden sollen. Gerade letzteres ist aber of von Vorteil, wenn komplexe Korrekturvorgänge vorgenommen werden sollen. Die Erfindung ermöglich somit auch die Erzeugung verschiedenster Multipolfelder in komplexen Anordnungen, insbesondere Überlagerungen. Dabei sind separate Ansteuerungen der einzelnen Multipolspulen möglich.

Bezüglich der Multipolspulen ist noch anzumerken, daß die erzeugten Multipolfelder nicht unbedingt mit der Polspulenanzahl übereinstimmen müssen. Wenn man beispielsweise bei einem Zwölfpolelement die Strombeaufschlagung so regelt, daß sich immer zwei Nordpole und dann zwei Südpole abwechseln, so erzeugt man ein Hexapolfeld. Auf diese Art läßt sich auch ein Dipol- oder Quadrupolfeld erzeugen. Sogar ein Oktupolfeld ist machbar, wenn man einen gewissen Teilungsfehler in Kauf nimmt. Durch übereinanderliegende Multipolspulen der Erfindung können aber auch Felder übereinandergelegt werden, die sich mit einem Multipolelement nicht durch reine Strombeaufschlagung ohne Teilungsfehler erzeugen lassen. Es können außer den eingangs erwähnten Multipolen auch solche mit einer ungeraden Polzahl, also beispielsweise mit drei, fünf oder sieben Polen hergestellt werden.

Durch die Erfindung ist es möglich, Multipole für die Fehlerkorrektur in der Teilchenoptik mit einem sehr geringen Platzbedarf herzustellen. Zur Unterbringung von gewickelten Spulen des Standes der Technik wären wesentlich größere Aussparungen, beispielsweise in einer magnetischen Linse, erforderlich. Dies führt bei einer solchen Linse zu einer Geometrieveränderung, welche negative Rückwirkungen auf das erzeugte Magnetfeld hat. Der kleine Bauraum der erfindungsgemäßen Multipolspulen ermöglicht es, solche Geometrieveränderungen ganz oder größtenteils zu vermeiden. Damit kann ein Korrekturelement bei möglichst geringer Störung des Linsenfeldes eingefügt werden.

Herkömmlich gebaute Multipole, die in der Teilchenoptik zur Fehlerkorrektur um einen Strahlrohrbereich von 6 bis 10 mm angeordnet wurden, führten zu einem Außendurchmesser, der ca. 2 cm größer ist als der Strahlrohrbereich. Die erfindungsgemäßen Multipolspulen benötigen weniger als 1 cm Durchmesservergrößerung, meist reichen sogar Wandstärken der gerollten Leiterplatten - auch wenn diese mehrere Lagen aufweisen - von weniger als 3 mm.

In der Regel wird dabei die Leiterplatte zu einem zyindermantelförmigen Körper gerollt. Die Form könnte jedoch auch davon abweichen, statt einem kreisringförmigen Querschnitt könnte die Rolle auch einen vieleckförmigen Querschnitt aufweisen, wobei natürlich die Ecken entsprechend der Verformbarkeit der Leiterplatte abgerundet sein müßten.

Die Herstellung kann mittels einer Standard-Leiterplattentechnologie erfolgen, wobei durch das lithographische oder ein ähnliches übliches Herstellungsverfahren in reproduzierbarer Weise immer eine exakte Lage der Windungen der Multipolspulen erzielbar ist. Dies ermöglicht eine wirtschaftliche Massenfertigung mit sehr hoher Genauigkeit, und der Aufwand für Hand- oder Maschinenwicklungen um Stege entfällt. Gerade letzteres ist oft nicht einfach, da die Drähte um die Stege herumgeführt werden müssen. Sind zwei Spulenkörper in Achsrichtung übereinander angeordnet, ist der Steg des einen Spulenkörpers bei der Wicklung des anderen im Weg und eine Wicklungsherstellung ist selbst von Hand kaum möglich.

Durch die höhere Herstellungsgenauigkeit sind die hergestellten Exemplare nahezu gleich und der bisher zu betreibende hohe Kalibrieraufwand, bei dem durch eine entsprechende Veränderung der Strombeaufschlagung Herstellungsunterschiede kompensiert werden mußten, entfällt. Dies verbilligt und vereinfacht die Herstellung, insbesondere bei größeren Stückzahlen, erheblich. Kapazitive Eigenschaften der Erregerspulen können gezielt beeinflußt - beispielsweise minimiert - werden, indem Leiterabstände oder die dielektrischen Eigenschaften der Leiterplatte entsprechend gewählt werden.

Bei den bisherigen Multipolen für die Fehlerkorrektur in der Teilchenoptik waren auch Winkelfehler bezüglich der Teilung der Pole unvermeidbar, da Stege und Wicklungen nicht exakt genug herstellbar waren, dieses Problem tritt bei der Erfindung nicht auf, da beim Rollen der Leiterplatten eine wesentlich exaktere Positionierung möglich ist.

Ein weiterer Vorteil ist eine bessere Wärmeabfuhr, da bei der Herstellung von Wicklungen Abstände zwischen den Drähten auftreten, in denen sich Luft befindet. Exakt aufeinanderliegende Leiterplatten sorgen dagegen für eine bessere Wärmeabfuhr.

Die durch die Spulen erzeugten Felder können außer durch Stromerhöhung auch dadurch verstärkt werden, daß mehrere Windungen pro Spule durch eine spiralförmige Anordnung oder durch mehrere beim Rollen erzeugte Leiterplattenlagen erzeugt werden. Selbstverständlich ist auch eine Kombination von beidem möglich und führt zu einer besonders effektiven Felderzeugung. Bei mehreren Lagen müssen natürlich Maßnahmen getroffen werden, daß als Spulen zusammenwirkende Windungen oder spiralförmigen Anordnungen von Windungen sehr exakt zueinander positioniert werden.

Zweckmäßigerweise wird vorgesehen, daß die Windungen der Spulen der verschiedenen Leiterplattenlagen derart verlaufen, daß die Wicklungsmitten in einer senkrecht zur Achse verlaufenden Ebene immer auf Radien liegen. Dadurch wird das durch die Windungen der Spulen gebildete Fenster von innen nach außen entsprechend des Radienverlaufs verbreitert. Da bei einem Hexapol sechs Spulen vorgesehen sind, ergibt sich beispielsweise jeweils ein Öffnungswinkel von ca. 60° in Bezug auf die Achse. Eine solche Ausgestaltung der Spulen war mit der herkömmlichen Technik nicht möglich. Der erzielte Vorteil besteht darin, daß wesentlich korrektere Felder der verschiedenen Multipole erzeugbar sind, da der Abstand zwischen einzelnen Spulen gering gehalten werden kann. Dies ist insbesondere bei einer größeren Anzahl von Polen wichtig. Außerdem sind die erzeugten Felder durch exakte Positionierungen der Windungen wesentlich besser reproduzierbar.

Bei einer spiralförmigen Anordnung von Windungen in mehreren Leiterplattenlagen weisen zweckmäßigerweise die äußeren spiralförmigen Anordnungen mehr Windungen auf als die inneren. Dies ist zum einen dadurch möglich, daß in diesem Bereich mehr Platz vorhanden ist und hat den Vorteil, daß mit zunehmender Entfernung von der Achse eine stärkere Felderregung zustande kommt, so daß im Bereich der Achse ein möglichst starkes Feld mit einer homogenen Multipolfeldstärke vorhanden ist. Dabei befinden sich die oben genannten Wicklungsmitten in der Mitte der nebeneinander liegenden Leiterbahnen der spiralförmigen Anordnung, so daß auch bezüglich dieser die genannte Fenstervergrößerung nach außen möglich ist. Die nach außen stärkere Felderregung wäre natürlich auch mittels größerer Leiterquerschnitte und größerer Strombeaufschlagung möglich, dann wären aber in der Regel separate Stromzuleitungen erforderlich.

Eine weitere Verbesserung der Felderregung kann dadurch erzielt werden, daß die Zahl der Windungen pro Leiterplattenlage verdoppelt wird, indem die Leiterplatte an ihrer Vorder-und Rückseite Leiterbahnen trägt, die Windungen bilden. Dabei müssen natürlich die Leiterbahnen der Leiterplattenlagen durch eine Isolierschicht getrennt werden.

Die Anschlüsse und Verbindungen der verschiedenen zu einer Spule gehörenden Windungen könnten zwar über Leiterbahnen auf den Leiterplatten erfolgen, was jedoch die Nachteile von Platzbedarf und einer Erzeugung von Störfeldern hätte. Deshalb wird vorgeschlagen, daß verschiedene Ebenen von Leiterbahnen mittels durch die Leiterplatte hindurchgehenden Durchkontaktierungen miteinander verbunden werden. Auf diese Weise lassen sich alle zu einer Spule gehörenden Windungen auf einfache Weise miteinander verbinden und es ist dann nur noch erforderlich, über Bahnen auf den Leiterplatten oder über Bahnen in Verbindung mit Durchkontaktierungen die verschiednen Spulen eines Multipols miteinander zu verschalten.

Bezüglich der Leiterbahnen ist zur Erzeugung entsprechend starker Felder eine hohe Stromleitfähigkeit erwünscht. Aus diesem Grund wird vorgeschlagen, daß die Querschnittsfläche der Leiterbahnen durch galvanische Verstärkung erhöht wird. Die Leiterbahnen müssen dabei aus gut leitfähigem Material bestehen, üblicherweise Kupfer.

Die erzeugten Felder werden um so genauer, je exakter die Windungen der jeweiligen Spulen positioniert sind. Um eine solche Positionierung bei der Erzeugung mehrere Leiterplattenlagen beim Rollen zu erhalten, wird vorgeschlagen, daß Justagemarken auf den Leiterplatten für diese Positionierung vorgesehen sind. Dabei können die Justagemarken Bohrungen sein, durch die ein Dorn gesteckt wird. Anschließend werden die Leiterplatten zweckmäßigerweise großflächig miteinander verklebt, um die exakte Position zu sichern und gleichzeitig für eine gute Wärmeabfuhr zu sorgen.

Um eine solche Wärmeabfuhr noch zu verbessern, können thermisch leitende Materialien eingesetzt werden, die den Wärmefluß nach außen ableiten. Dazu kann der Klebstoff für das Verkleben der Leiterplatten selbst dienen, wenn dieser gut wärmeleitend ist. Für diesen Zweck können natürlich auch zusätzliche Materialien vorgesehen sein.

Auf oder an der Leiterplatte können auch noch zusätzliche elektrische oder elektronische Bauelemente angeordnet werden, beispielsweise mit Meß- und Regelungsfunktionen.

Die von ihrem Grundaufbau kernlosen Spulen können selbstverständlich auch mit einem hart- oder weichmagnetischen Kern ausgestattet werden, oder es können an beliebigen Stellen weich- oder hartmagnetische Materialien zur Beeinflussung des magnetischen Flusses eingesetzt werden. Dazu können Hohlräume der Leiterplatte dienen, die man beispielsweise mittels Durchbrechungen im Fensterbereich der Spulen herstellen kann. An der Außenseite der Leiterplatte kann dann ebenfalls magnetisches Material angeordnet werden, welches die Kerne der Spulen als Joch verbindet.

Ein weiterer Einsatzzweck der Multipolspule wäre die Erfassung magnetischer Multipolfelder, also beispielsweise Dipol- oder Quadrupolfelder usw., die in den entsprechenden Multipolspulen Ströme induzieren und sich die Multipolfelder dadurch bezüglich ihrer Lage und ihrer Intensität erfassen lassen. Die Multipolspulen gemäß Anspruch 1 sind dazu identisch aufgebaut, üben jedoch die reziproke Funktion aus, die darin besteht, daß sie diese Felder nicht erzeugen, sondern erfassen.

Wie bereits oben erwähnt, ist das Einsatzgebiet derartiger Multipolspulen die Teilchenoptik, insbesondere die Elektronenoptik. Dazu werden die Multipolspulen zweckmäßigerweise um ein Vakuumrohr angeordnet, in dem die optische Achse liegt. Bei dem Einsatzzweck, daß sich in oben genannter Art Abbildungsfehler korrigieren lassen, geht es insbesondere um die Korrektur geringfügiger Produktionsfehler, welche durch mechanische Ungenauigkeiten der Linsen auftreten. Dies ist insbesondere in der Elektronenmikroskopie von Bedeutung, wenn hohe Bildauflösungen gefordert werden, die ohne solche Korrekturen nicht möglich sind.

Die erfindungsgemäße Anordnung hat den besonderen Vorteil, daß mehrere gleiche oder auch verschiedene Multipole auf einer Leiterplatte angeordnet werden können. So lassen sich, wie bereits erwähnt, beispielsweise zwei Dipole anordnen, oder es ist auch möglich, Dipole, Quadrupole, Hexapole, Oktopole usw. auf einer Leiterplatte anzuordnen, um kombinierte Multipolfelder zu erzeugen, wobei jeder Multipol zweckmäßigerweise separat angesteuert wird und es auf diese Weise möglich ist, Bildfehler verschiedener Ordnungen mit ein und derselben Vorrichtung zu korrigieren. Dazu müssen die Multipole separate Anschlüsse zur Strombeaufschlagung aufweisen. Selbstverständlich können Multipole auch direkt oder unter Einfügung weiterer Bauelemente miteinander verschaltet werden, um für eine entsprechende Beeinflussung des Teilchenstrahls Überlagerungen verschiedener Mehrpolfelder zu erzeugen, welche dazu in einer bestimmten Relation zueinander stehen müssen.

Ein besonders zweckmäßiges Beispiel der Anordnung mehrere Multipole kann auch sein, daß ein Dipol und ein zu diesem um 90° gedrehter weiterer Dipol auf ein und derselben Leiterplatte angeordnet sind. Werden diese zwei Dipole auf verschiedenen Leiterplattenlagen angeordnet, können sich beide in oben genannter Art über einen Winkel von 120° je Spule erstrecken, da nicht nur Aneinandergrenzungen, sondern auch Überlappungen möglich sind. Dadurch lassen sich besonders exakte und effektive Felder ausbilden, die bei Spulen nach dem Stand der Technik überhaupt nicht möglich sind. Bei der vorgenannten oder anderen Kombinationen können mehrere Multipolspulen, beispielsweise auf mehrere Leiterplattenlagen verteilt, angeordnet sein, oder es ist auch möglich, daß mehrere Multipolspulen in Achsrichtung übereinander angeordnet sind. Auch Kombinationen aus beiden Anordnungen sind möglich. In jedem dieser Fälle besteht der Vorteil in einer exakten Zuordnung dieser Multipolspulen zueinander, ohne daß irgendein nennenswerter Winkelfehler bei der Zuordnung auftritt. Auch ist es einfach, eine Leiterplatte lediglich in mehreren Lagen zu rollen, um eine derartige Anordnung zu erhalten.

Solche Kombinationen von mehreren verschiedenen Multipolspulen dienen in der Teilchenoptik vorzugsweise der Korrektur verschiedenster Abbildungsfehler unterschiedlicher Ordnungen. Dies ermöglicht eine Korrektur nahezu aller auftretenden Fehler mit einem einzigen Korrekturelement.

Um die Bauhöhe der jeweiligen teilchenoptischen Vorrichtung durch Einbringung der Multipolspulen nicht noch mehr zu erhöhen, kann vorgesehen sein, daß die Anordnung der Leiterplatte in der Strahlendurchtrittsöffnung einer Linse erfolgt. Selbstverständlich können mit einer solchen Multipolspule auch Korrekturen von Fehlern vor- oder nachgeordneter Linsen erfolgen.

Bei einer magnetischen Linse ist es zweckmäßig, wenn die Anordnung zwischen dem magnetischen Spalt und der Linsenbegrenzung erfolgt, wobei - falls bezüglich des Platzbedarfs erforderlich - eine entsprechende Erweiterung der Strahldurchtrittsöffnung, beispielsweise durch eine Aussparung, möglich ist, so daß die Multipolspulen zwischen der inneren Linsenwandung und dem Vakuumrohr Platz finden. Die Leiterplatte mit den Multipolspulen läßt sich natürlich auch in andere Aussparungen eines teilchenoptischen Elements einfügen, wobei es auch möglich ist, die Leiterplatte in einfacher Weise beim Rollen in eine Vertriefung hineinzulegen, gegebenenfalls in mehreren Lagen.

Gerade bei solchen Anordnungen in Linsen einer teilchenoptischen Vorrichtung, wie eines Elektronenmikroskops, kommen die Vorteile der geringen Bauhöhe in radialer Richtung zum Tragen. Zum einen ist durch die geringe Bauhöhe eine solche Anordnung oft überhaupt erst möglich und verringert dadurch die Bauhöhe einer solchen Vorrichtung. Zum anderen sorgt die geringe Bauhöhe dafür, daß die Geometrie einer solchen Linse nicht oder fast nicht verändert werden muß. Dadurch wird nicht nur vermieden, daß neue Fehlerquellen entstehen können, es eröffnen sich dadurch auch Korrekturmaßnahmen an Orten, an denen diese bisher nicht möglich waren.

Die Erfindung wird nachfolgend anhand von in der Zeichnung dargestellten Ausführungbeispielen erläutert. Es zeigen
- **Fig. 1**: eine einfache Ausführungsform der Erfindung zur Erläuterung des Grundprinzips,
- **Fig. 2**: ein Ausführungsbeispiel mit einer Rollung einer Leiterplatte in mehrere Leiterplattenlagen als Schnittansicht,
- **Fig. 3**: eine Rollung der Leiterplatte in mehreren Lagen in räumlicher Ansicht,
- **Fig. 4**: ein Schnitt durch eine Leiterplatte mit Leiterbahnen,
- **Fig. 5**: ein Schnitt durch einen Dipol,
- **Fig. 6**: ein Schnitt durch zwei in verschiedenen Leiterplattenlagen angeordnete Dipole,
- **Fig. 7**: ein Beispiel einer Spulenanordnung eines Dipols,
- **Fig. 8**: ein Beispiel einer Spulenanordnung eines Quadrupols,
- **Fig. 9**: ein Beispiel einer Spulenanordnung eines Hexapols,
- **Fig. 10**: eine Anordnung der erfindungsgemäßen Multipolspulen in einer Linse und
- **Fig. 11**: in einer Aussparung eines sonstigen teilchenoptischen Bauelements.

**Fig. 1** zeigt eine einfache Ausführungsform der Erfindung zur Erläuterung des Grundprinzips. Auf einer Leiterplatte 8 sind dabei zur Erzeugung eines Dipols 24 zwei Spulen 1 und 2 angeordnet, die aus jeweils einer Windung 7 bestehen. Jeder dieser Windungen 7 ist als Leiterbahn 9 auf der Leiterplatte 8 aufgebracht und wird mittels Anschlüssen 25 mit Strom beaufschlagt. Die Windungen 7 bilden rechteckförmige Fenster 16, die an den Ecken abgerundet sind, wobei die langen Seiten 17 der Fenster 16 in Richtung einer gedachten Achse 10 ausgerichtet sind. Die Achse 10 ist bei der Verwendung der Multipolspulen im Bereich der Teilchenoptik die optische Achse. Die Leiterplatte 8 ist aus biegsamem Material und zu einem innen hohlen Zylinder gerollt, so daß die beiden Spulen 1, 2 die Achse 10 konzentrisch einschließen.

**Fig. 2** zeigt ein Ausführungsbeispiel mit einer Rollung einer Leiterplatte 8 in mehreren Leiterplattenlagen 11, 12, 13, 14 im Schnitt. Bei diesen Multipolspulen 1, 2, 3, 4 handelt es sich um einen Quadrupol 31, da vier Spulen 1, 2, 3, 4 konzentrisch um eine gedachte Achse 10, also die optische Achse, angeordnet sind. Durch den Schnitt in einer Ebene 19 senkrecht zur Achse 10 sind dabei die Leiterbahnen 9 geschnitten sichtbar, die senkrecht zur Achse 10 verlaufen. Dabei ist deutlich, daß die Leiterbahnen 9 der Windungen 7 der verschiedenen Leiterplattenlagen 11, 12, 13, 14 exakt in radialer Richtung gestapelt sind. Dies ist zur Erzielung einer exakten Spulengeometrie und damit exakter Felder besonders wichtig, wenn die Multipolspulen 1, 2, 3, 4 in der Teilchenoptik zur Korrektur von Abbildungsfehlern eingesetzt werden sollen. Eine Verklebung kann die exakte Positionierung sichern.

Bei dieser Darstellung ist insbesondere gut sichtbar, wie gering die Bauhöhe einer derartigen Multipolspule ist, die hier im Bereich von vier Leiterplattenlagen 11, 12, 13, 14 liegt und auch bei einer größeren Anzahl von Multipolspulen, also beispielsweise einem Hexapol, Oktupol oder Zwölfpol, in dieser Bauhöhe ausgeführt sein kann. Vergleicht man dies mit den herkömmlichen, gewickelten Multipolspulen, beispielsweise mit der Abbildung in NanoS, Seite 27 (a.a.O.), so wird der Baugrößenunterschied ebenso deutlich, wie die dadurch veränderte Geometrie. So können mit weit geringerem Aufwand wesentlich reinere Multipolfelder erzeugt werden.

**Fig. 3** zeigt eine Rollung einer Leiterplatte 8 in mehreren Lagen 11, 12, 13, 14 in räumlicher Ansicht. Dabei ist an einem Beispiel gezeigt, wie die Leiterbahnen 9 als Windungen 7 in einer spiralförmigen Anordnung 15 ausgebildet sind. Es ist dabei nur eine spiralförmige Anordnung 15 beispielhaft gezeichnet, tatsächlich sind diese - genauso wie die in Fig. 2 dargestellten Windungen 7 - übereinandergelegt. Die Verbindung der Leiterbahnen 9 der spiralförmigen Anordnung 15 der verschiedenen Leiterplattenlagen 11, 12, 13, 14 kann mittels Durchkontaktierungen 23 erfolgen, so daß alle Windungen 7 einer Spule miteinander verbunden sind. Die zu einem Mehrpolelement gehörenden Spulen werden wieder in entsprechender Weise miteinander verschaltet, so daß abwechslungsweise ein Südpol und ein Nordpol der jeweiligen magnetischen Felder erzeugt wird. Dabei kann eine solche gerollte Leiterplatte 8 auch Spulen 1, 2, 3, 4, 5, 6 usw. mehrerer Multipole enthalten. Die an den Rändern geführten Zuleitungen 34 können der Verschaltung von Spulen eines Multipols dienen oder auch den Anschlüssen 25 zur Strombeaufschlagung von einem oder mehreren Multipolen. Auch hier ist gezeigt, wie die Windungen 7 rechteckförmige Fenster 16 bilden.

**Fig. 4** zeigt einen Schnitt durch eine Leiterplatte 8 mit Leiterbahnen 9. Hier sind die Leiterbahnen 9 an der Vorderseite 20 der Leiterplatte 8 aufgebracht und mit einer Isolierschicht 22 bedeckt. In derselben Weise können auch Leiterbahnen 9 auf der Rückseite 21 der Leiterplatte 8 angeordnet werden. Dies hat den Vorteil, daß doppelt so viele Windungen 7 oder spiralförmige Anordnungen 15 von Windungen 7 gebildet werden können, wie Leiterplattenlagen 11, 12, 13, 14 vorhanden sind. In einem solchen Fall ist die Isolierschicht 22 erforderlich, damit die Leiterbahnen 9 elektrisch getrennt sind. Beim Wickeln der Leiterplatte 8 ist es dann zweckmäßig, wenn noch ganzflächig eine Klebschicht aufgebracht wird, die die Positionierungen der Spulen sichert und dabei auch für eine bessere Wärmeabfuhr sorgt. Deshalb ist eine Verbindung ohne Lufträume zweckmäßig.

**Fig. 5** zeigt einen Schnitt durch einen Dipol 24, wobei hier die Leiterplatte 8 nicht dargestellt ist. Gezeigt ist hier, wie die Spulen 1 und 2 sich über einen Bereich von jeweils 120° erstrecken. Dies dient der Erzeugung eines sehr reinen Dipolfeldes. Bei der Darstellung sind die Leiterbahnen 9 in einer Ebene 19 senkrecht zur Achse 10 geschnitten und es sind die Wicklungsmitten 18 eingezeichnet, die bei solchen einfachen Windungen 7 in der Mitte der Leiterbahnen 9 verlaufen. Durch das Rollen der hier nicht gezeichneten Leiterplatte 8 erhalten die Leiterbahnen 9 die gezeichnete Kreisbogenform, was zur Erzeugung von Feldern, die möglichst präzise auf den Bereich der Achse 10 wirken sollen, ebenfalls von Vorteil ist.

**Fig. 6** zeigt einen ebensolchen Schnitt in einer Ebene 19 senkrecht zur Achse 10 mit auf zwei auf verschiedenen Leiterplattenlagen 11, 12 angeordneten Dipolen 24 und 24'. Dabei sind ebenfalls nur die Leiterbahnen 9 der Windungen 7 der Spulen 1 und 2 der jeweiligen Dipole 24 und 24' gezeichnet, jedoch nicht die Leiterplatte 8 mit ihren Lagen 11 und 12. Diese ist entsprechend der Fig. 2 und 3 in zwei Lagen gerollt. Damit ist ersichtlich, wie die Dipole 24 und 24' durch zwei Leiterplattenlagen 11, 12, übereinandergelegt werden können und dadurch eine Anordnung möglich ist, die mittels gewickelter Spulen des Standes der Technik nicht herstellbar ist. Um die erzeugten Magnetkräfte zu verstärken, können hier natürlich auch die Spulen 1 und 2 der jeweiligen Dipole 24 und 24' als spiralförmige Anordnungen 15 ausgebildet sein, und es ist möglich, auch hier mehr als zwei Leiterplattenlagen 11, 12 vorzusehen, damit die Anzahl der Windungen 7 der beiden Dipole 24 und 24' weiter vergrößert werden kann.

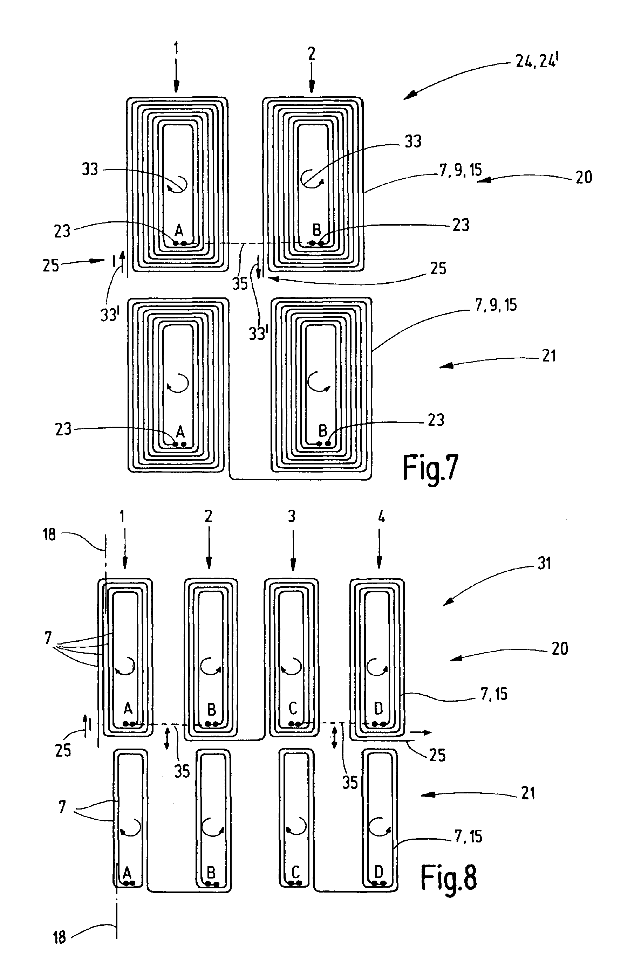

**Fig. 7** zeigt ein Beispiel einer Spulenanordnung 1, 2 eines Dipols 24 oder 24', bei dem Windungen 7 in spiralförmiger Anordnung 15 ausgebildet sind, wobei die Spulen 1 und 2 aus derartigen Windungen 7, 15 auf der Vorderseite 20 einer Leiterplatte - dargestellt im oberen Bereich der Fig. 7 - und zusätzlich Windungen 7, 15 auf der Rückseite 21 der Leiterplatte - dargestellt im unteren Bereich der Fig. 7 - gebildet sind. Auch hier ist die Leiterplatte 8 nicht dargestellt, sondern lediglich symbolisch die auf der Leiterplatte 8 aufgebrachten Leiterbahnen 9 der Vorderseite 20 im oberen Bildteil und im unteren Bildteil die Leiterbahnen 9 der Rückseite 21 der Leiterplatte 8. Die Durchkontaktierungen 23 sind bei A und bei B jeweils miteinander verbunden, so daß zwischen A und B im oberen Bildteil eine elektrische Verbindung 35 entsteht. Sie ist hier symbolisch in unterbrochener Linie gezeichnet und entspricht der Verbindung im unteren Bildteil über die Windungen 7 der spiralförmigen Anordnungen 15. Die Leiterplatte 8 ist entsprechend Fig. 1 gerollt. Der Dipol 24 oder 24' braucht dann nur noch über die Anschlüsse 25 mit Strom beaufschlagt zu werden, so daß dann ein Stromfluß entsteht, wie er durch die Pfeile 33 und 33' angedeutet ist. Auf diese Weise sind zwei Spulen 1, 2 verfügbar, welche umgekehrt gepolte Magnetfelder erzeugen.

**Fig. 8** zeigt ein Beispiel einer Spulenanordnung mit den Spulen 1, 2, 3 und 4, welche einen Quadrupol 31 bilden. Die Darstellung entspricht der oben beschriebenen, wobei hier die Verschaltung entsprechend variiert ist, derart, daß die im oberen Teil gezeichneten Verbindungen 35 nur zwischen den Spulen 1 und 2 und den Spulen 3 und 4 über die entsprechenden Windungen 7 auf der Rückseite 21 der Leiterplatte erfolgen und die Verbindung der Windungen 7 der Vorderseite 20 der Leiterplatte unmittelbar zwischen den Spulen 2 und 3 erfolgt. Auf diese Weise wird bei dem Quadrupol 31 ebenfalls eine Verschaltung der Spulen 1, 2, 3 und 4 hergestellt, die dazu führt, daß sich bei den Magnetfeldern die Nord- und Südpole einander abwechseln. Selbstverständlich wird auch hier die Leiterplatte 8 derart gerollt, daß die Spulen 1, 2, 3, 4 die Achse 10 konzentrisch einschließen.

Bei dieser Darstellung ist noch gezeigt, daß die spiralförmige Anordnung 15 auf der Vorderseite 20 der Leiterplatte 8 mehr Windungen 7 aufweist als die spiralförmige Anordnung 15 auf der Rückseite 21 der Leiterplatte 8. Dadurch wird, wenn die Leiterplatte 8 derart gerollt wird, daß ihre Rückseite 21 nach innen und ihre Vorderseite 20 nach außen zeigt, erreicht, daß die äußeren spiralförmigen Anordnungen 15 mehr Windungen 7 aufweisen, als die inneren. Mit den strichpunktierten Linien ist gezeigt, daß die Wicklungsmitten 18 bei jeder spiralförmigen Anordnung 15 in der Mitte der Windungen 7 liegen, die die jeweiligen spiralförmigen Anordnungen 15 bilden. Diese Wicklungsmitten 18 müssen dann derart liegen, daß sie sich alle in einer senkrecht zur Achse 10 liegenden Ebene 19 mit den Radien decken. Dies gilt nicht nur für die Vorderseite 20 und die Rückseite 21 einer Leiterplatte 8, sondern ebenfalls für mehrere Leiterplattenlagen 11, 12, 13, 14 usw.

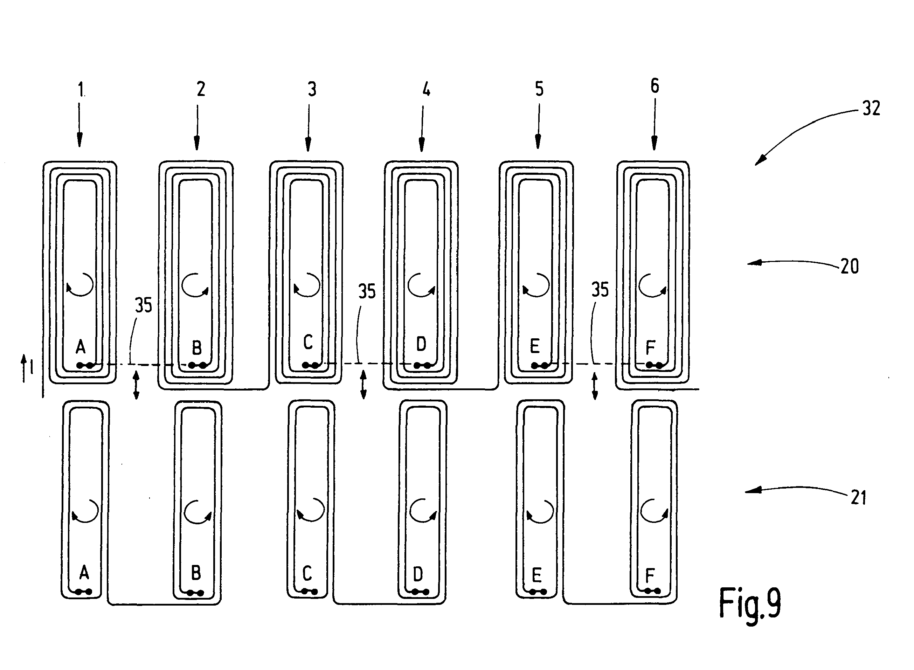

**Fig. 9** zeigt noch ein Beispiel einer Spulenanordnung eines Hexapols 32 mit sechs Spulen 1, 2, 3, 4, 5, 6. Auch hier sind die Windungen 7 in spiralförmigen Anordnungen 15 auf der Vorderseite 20 der Leiterplatte 8 (oben) und der Rückseite 21 der Leiterplatte 8 (unten) gezeichnet, wobei die Leiterplatte 8 selbst nicht gezeichnet ist. Auch hier ist mittels der Doppelpfeile angedeutet, daß die elektrischen Verbindungen 35 zwischen A und B, C und D, E und F der Windungen 7 der Vorderseite 20 über die Windungen 7 auf der Rückseite 21 erfolgt, indem an den Punkten A, B, C, D, E und F Durchkontaktierungen vorgesehen sind. Im übrigen gilt das oben beschriebene.

Die **Fig. 10** zeigt eine Anordnung der erfindungsgemäßen Multipolspulen 1, 2, 3, 4, 5, 6 in einer Linse 26, welche als magnetische Linse ausgebildet ist. Die Aufzählung der sechs Spulen sind natürlich nur beispielhaft, dort können in oben genannte Weise beliebige Multipolelemente angeordnet sein, auch eine Kombination mehrerer Multipolelemente. Die Anordnung dieser findet vorzugsweise unterhalb des durch die Polschuhe 37 gebildeten magnetischen Spaltes 28 statt und zwar in der Strahldurchtrittsöffnung 27 der Linse 26. Das Gehäuse der Linse 26 ist hier geschnitten dargestellt, so daß durch den aufgeschnittenen Eisenmantel 39 die ebenfalls geschnittenen Wicklungen 38 sichtbar sind. Ebenso ist der Verlauf des durch die Linse 26 beeinflußten Elektronenstrahls 36 sichtbar. Da die erfindungsgemäßen Multipolspulen 1, 2, 3, 4, 5, 6 einen sehr kleinen Bauraum benötigen, können sie entweder unmittelbar in der Strahldurchtrittsöffnung 27 der Linse 26 angeordnet werden, ohne den Elektronenstrahl 36 zu behindern, oder es kann bei größerem Raumbedarf auch eine Aussparung in der Strahldurchtrittsöffnung 27 vorgesehen sein, in die die Leiterplatte 8 mit den Multipolen eingelegt wird.

**Fig. 11** zeigt eine solche Aussparung 29 in einem beliebigen teilchenoptischen Bauelement, wie beispielsweise einem Stahlrohr 30. Eine solche Aussparung 29 kann sich sowohl an der Außenseite befinden - wie hier gezeigt -, oder was der Linse 26 in Fig. 10 entsprechen würde, an der Innenseite der Strahldurchtrittsöffnung 27. Dabei ist es ohne weiteres möglich, Leiterplattenlagen 11, 12, 13 usw. in eine beliebige Ausnehmung 29 hineinzulegen. Die Gestaltung der Aussparung 29 muß also nicht derart sein, daß die gerollte Leiterplatte 8 durch Aufschieben anbringbar ist.

Die Zeichnungen zeigen selbstverständlich nur symbolisch einige wenige Ausführungmöglichkeiten. Es sind viele Variationen denkbar, so könnten die Windungen 7 auch in Kreisen oder Ovalen gelegt sein, es könnten die Rechteckformen auch eine andere Lage einnehmen oder es könnten wesentlich komplexere Anordnungen vorgesehen sein, indem in vielen Leiterplattenlagen 11, 12, 13, 14 viele Multipolspulen 1, 2, 3, 4, 5, 6 angeordnet sind, die zur Korrektur einer Vielzahl von Abbildungsfehlern in der Teilchenoptik dienen. Je nach diesem Einsatzzweck muß natürlich auch eine entsprechende Verschaltung der verschiedenen Spulen vorgenommen werden, wobei auch separate Ansteuerungen einzelner Spulen möglich wären, oder Verschaltungen von mehreren Multipolspulen miteinander, möglicherweise auch unter Einfügung weiterer elektrischer oder elektronischer Bauelemente. Diesbezüglich soll die Zeichnung lediglich eine beispielhafte Vorstellung von der Erfindung vermitteln.

### Bezugszeichenliste

- 1, 2, 3, 4, 5, 6: Multipolspulen bzw. Spulen
- 7: Windungen
- 8: Leiterplatte
- 9: Leiterbahnen
- 10: Achse, gedachte (z. B. optische Achse)
- 11, 12, 13, 14: Leiterplattenlagen
- 15: spiralförmige Anordnung
- 16: rechteckförmige Fenster
- 17: lange Seiten der Fenster
- 18: Wicklungsmitten
- 19: senkrecht zur Achse verlaufende Ebene
- 20: Vorderseite der Leiterplatte
- 21: Rückseite der Leiterplatte
- 22: Isolierschicht
- 23: Durchkontaktierungen
- 24: Dipol
- 24': weiterer Dipol
- 25: Anschlüsse zur Strombeaufschlagung
- 26: Linse
- 27: Strahldurchtrittsöffnung einer Linse
- 28: magnetischer Spalt
- 29: Aussparung
- 30: teilchenoptisches Bauelement, z. B. Stahlrohr
- 31: Quadrupol
- 32: Hexapol
- 33, 33': Stromlaufrichtung
- 34: Zuleitungen
- 35: Verbindung über Wicklungen auf der Rückseite der Leiterplatte
- 36: Elektronenstrahl
- 37: Polschuhe
- 38: Wicklungen
- 39: Eisenmantel

- A, B, C, D, E, F: Durchkontaktierungen

## Patentansprüche

1. Multipolspulen (1, 2, 3, 4, 5, 6) zur Beeinflussung von Teilchenstrahlen mit mindestens zwei Spulen (1, 2), die eine gedachte Achse (10) konzentrisch einschließend angeordnet sind, wobei für jede Spule (1, 2, 3, 4, 5, 6) mindestens eine Windung (7) auf einer flexiblen Leiterplatte (8) durch aufgebrachte Leiterbahnen (9) angeordnet wird und die Leiterplatte (8) mindestens in einer Leiterplattenlage (11, 12, 13, 14) gerollt wird,
**dadurch gekennzeichnet,**
**daß** die Windungen (7) der Multipolspulen (1, 2, 3, 4, 5, 6) Fenster (16) bilden, deren Breite in Umfangsrichtung derart gewählt ist, daß keine sekundär erzeugten Störfelder auftreten, und deren Länge in Achsrichtung mindestens der Breite entspricht.

2. Multipolspulen nach Anspruch 1,
**dadurch gekennzeichnet,**
**daß** die Windungen (7) im Wesentlichen rechteckförmige Fenster (16) bilden, wobei die langen Seiten (17) der Fenster (16) in Achsenrichtung eine derartige Länge aufweisen, daß .entlang der Achse eine homogene Multipolfeldstärke in einer Ausdehnung entsteht, die den für die gewünschte Fehlerkorrektur erforderlichen Fundamentalbahnverlauf der Teilchenstrahlen erzeugt.

3. Multipolspulen nach Anspruch 1 oder 2,
**dadurch gekennzeichnet,**
**daß** zur Erzielung großer Fenster (16) bei Multipolspulen (1, 2, 3, 4, 5, 6) mit vier oder mehr Spulen (1, 2, 3, 4, 5, 6) diese auf der Leiterplatte (8) sehr eng aneinanderliegen.

4. Multipolspulen nach Anspruch 1, 2 oder 3
**dadurch gekennzeichnet,**
**daß** zur Erzielung großer Fenster (16) die Multipolspulen (1, 2, 3, 4, 5, 6) in verschiedenen Lagen (11, 12, 13, 14) angeordnet sind, und sich die Spulen (1, 2, 3, 4, 5, 6) überlappen.

5. Multipolspulen nach Anspruch 4,
**dadurch gekennzeichnet,**
**daß** bei einem Dipol (24) die Wicklungsmitten (18) der Windungen (7) einer jeden Spule (1, 2) auf Radien liegen, die zur Achse (10) einen Winkel von ungefähr 120° bilden.

6. Multipolspulen nach einem der Ansprüche 1 bis 5,
**dadurch gekennzeichnet,**
**daß** mehrere Windungen (7) pro Spule (1, 2, 3, 4, 5, 6) durch eine spiralförmige Anordnung (15) erzielt werden.

7. Multipolspulen nach einem der Ansprüche 1 bis 6,
**dadurch gekennzeichnet,**
**daß** mehrere Windungen (7) pro Spule (1, 2, 3, 4, 5, 6) durch mehrere beim Rollen erzeugte Leiterplattenlagen (11, 12, 13, 14) erzeugt werden.

8. Multipolspulen nach Anspruch 7,
**dadurch gekennzeichnet,**
**daß** die Windungen (7) der Spulen (1, 2, 3, 4, 5, 6) der verschiedenen Leiterplattenlagen (11, 12, 13, 14) derart verlaufen, daß die Wicklungsmitten (18) in einer senkrecht zur Achse (10) verlaufenden Ebene (19) immer auf Radien liegen, so daß sich die durch die Windungen (7) der Spulen (1, 2, 3, 4, 5, 6) gebildeten Fenster (16) von innen nach außen entsprechend des Radienverlaufs verbreitern und so der Abstand zwischen den Spulen (1, 2, 3, 4, 5, 6) gering gehalten wird.

9. Multipolspulen nach einem der Ansprüche 6 bis 8,
**dadurch gekennzeichnet,**
**daß** bei einer spiralförmigen Anordnung (15) von Windungen (7) in mehreren Leiterplattenlagen (11, 12, 13, 14) die äußeren spiralförmigen Anordnungen (15) mehr Windungen (7) als die inneren aufweisen.

10. Multipolspulen nach Anspruch 9,
**dadurch gekennzeichnet,**
**daß** sich die auf Radien liegenden Wicklungsmitten (18) in der Mitte der nebeneinander liegenden Leiterbahnen (9) der spiralförmigen Anordnung (15) befinden, so daß eine Fenstervergrößerung nach außen entsteht.

11. Multipolspulen nach einem der Ansprüche 1 bis 10,
**dadurch gekennzeichnet,**
**daß** die Zahl der Windungen (7) pro Leiterplattenlage (11, 12, 13, 14) **dadurch** verdoppelt wird, daß die Leiterplatte (8) an ihrer Vorder- (20) und Rückseite (21) Leiterbahnen (9) trägt, die Windungen (7) bilden, und daß die Leiterbahnen (9) der Leiterplattenlagen (11, 12, 13, 14) durch eine Isolierschicht (22) getrennt sind.

12. Multipolspulen nach einem der Ansprüche 6 bis 11,
**dadurch gekennzeichnet,**
**daß** verschiedene Ebenen von Leiterbahnen (9) mittels Durchkontaktierungen (23) miteinander verbunden sind.

13. Multipolspulen nach einem der Ansprüche 1 bis 12,
**dadurch gekennzeichnet,**
**daß** die Querschnittsfläche der Leiterbahnen (9) durch galvanische Verstärkung erhöht wird.

14. Multipolspulen nach einem der Ansprüche 6 bis 13,
**dadurch gekennzeichnet,**
**daß** zur Erzielung von Leiterplattenlagen (11, 12, 13, 14) mit einer exakten Positionierung der Windungen (7) der jeweiligen Spulen (1, 2, 3, 4, 5, 6) Justagemarken auf den Leiterplatten dienen.

15. Multipolspulen nach einem der Ansprüche 6 bis 14,
**dadurch gekennzeichnet,**
**daß** die Justagemarken Bohrungen sind, durch die ein Dorn gesteckt wird.

16. Multipolspulen nach einem der Ansprüche 6 bis 15,
**dadurch gekennzeichnet,**
**daß** die Leiterplattenlagen (11, 12, 13, 14) miteinander verklebt werden.

17. Multipolspulen nach einem der Ansprüche 6 bis 16,
**dadurch gekennzeichnet,**
**daß** thermisch leitende Materialien eingebracht werden, um den Wärmefluß besser nach außen zu leiten.

18. Multipolspulen nach einem der Ansprüche 1 bis 17,
**dadurch gekennzeichnet,**
**daß** zusätzliche elektrische oder elektronische Bauelemente auf der Leiterplatte (8) angeordnet werden.

19. Multipolspulen nach einem der Ansprüche 1 bis 18,
**dadurch gekennzeichnet,**
**daß** weich- oder hartmagnetische Materialien zur Beeinflussung des magnetischen Flusses in die Leiterplatte (8) eingesetzt werden.

20. Multipolspulen nach einem der Ansprüche 1 bis 19,
**dadurch gekennzeichnet,**
**daß** sie in reziproker Funktion zur Erfassung magnetischer Multipolfelder dienen.

21. Multipolspulen nach einem der Ansprüche 1 bis 20,
**dadurch gekennzeichnet,**
**daß** sie um ein Vakuumrohr angeordnet sind.

22. Multipolspulen nach einem der Ansprüche 1 bis 21,
**dadurch gekennzeichnet,**
**daß** mehrere gleiche oder verschiedene Multipole (Dipol, Quadrupol, Hexapol, Oktopol, usw.) auf einer Leiterplatte (8) angeordnet sind.

23. Multipolspulen nach Anspruch 22,
**dadurch gekennzeichnet,**
**daß** die Multipole separate Anschlüsse (25) zur Strombeaufschlagung aufweisen.

24. Multipolspulen nach eine der Ansprüche 1 bis 23,
**dadurch gekennzeichnet,**
**daß** ein Dipol (24) und ein zu diesem um 90° gedrehter weiterer Dipol (24') angeordnet sind.

25. Multipolspulen nach einem der Ansprüche 1 bis 24,
**dadurch gekennzeichnet,**
**daß** mehrere Multipole auf mehrere Leiterplattenlagen (11, 12, 13, 14) verteilt angeordnet sind.

26. Multipolspulen nach einem der Ansprüche 1 bis 25,
**dadurch gekennzeichnet,**
**daß** mehrere Multipole in Achsrichtung übereinander angeordnet sind.

27. Multipolspulen nach einem der Ansprüche 1 bis 26,
**dadurch gekennzeichnet,**
**daß** die Anordnung der Leiterplatte (8) in der Strahlendurchtrittsöffnung (27) einer Linse (26) erfolgt.

28. Multipolspulen nach Anspruch 27,
**dadurch gekennzeichnet,**
**daß** die Anordnung in einer magnetischen Linse (26) zwischen Linsenbegrenzung und magnetischem Spalt (28) erfolgt.

29. Multipolspulen nach einem der Ansprüche 1 bis 28,
**dadurch gekennzeichnet,**
**daß** die Leiterplatte (7) in eine Aussparung (29) eines teilchenoptischen Bauelements (30) eingefügt ist.
